# FASCICULE DE BREVET EUROPEEN

(11) **EP 1 073 202 B1**
(45) Date de publication et mention de la délivrance du brevet: **09.10.2002**
(21) Numéro de dépôt: 00402166.3
(22) Date de dépôt: 27.07.2000
(51) Int. Cl.: H03K 17/10, G11C 16/12

(54) **Dispositif de commande d'un commutateur haute tension de type translateur**
Steuerschaltung für einen Pegelumsetzer-Hochspannungsschalter
Device for controlling a high voltage switch of the tranlator type

(30) Priorité: 30.07.1999 FR 9909969
(43) Date de publication de la demande: 31.01.2001
(73) Titulaire: STMicroelectronics S.A., 92120 Montrouge (FR)
(72) Inventeur: Fournel, Richard, 94230 Cachan (FR)
(74) Mandataire: Ballot, Paul

(56) Documents cités:
- EP-A- 0 774 838
- GB-A- 2 201 059

## Description

La présente invention concerne un dispositif de commande d'un commutateur haute tension de type translateur.

Un exemple d'application concerne les circuits intégrés comprenant des mémoires non volatiles électriquement programmables.

Ces mémoires utilisent en effet pour leur programmation, une tension de niveau supérieur à la tension d'alimentation logique Vcc du circuit intégré. La valeur nominale de cette haute tension de programmation dépend essentiellement de la technologie considérée.

Pour appliquer cette haute tension à un élément du circuit intégré, par exemple pour l'appliquer sur une rangée d'une mémoire, on utilise habituellement un commutateur haute tension, appelé encore translateur de niveaux.

Ce commutateur reçoit en entrées, un signal logique de commande et une entrée haute tension. En fonction du niveau logique Vcc ou 0 du signal logique de commande, qui dans le cas d'une mémoire sera issu d'un signal de commande d'écriture, on obtient en sortie du commutateur, soit la masse, soit le niveau de l'entrée haute tension. Ces commutateurs sont bien connus de l'homme du métier.

Dans l'invention, on s'intéresse plus particulièrement aux commutateurs CMOS. Ils comprennent habituellement deux branches, avec dans chaque branche deux transistors en série entre l'entrée haute tension et la masse. Les transistors du bas sont de type N et ont leurs sources connectées à la masse. Ils sont encore appelés transistors de commutation, car ce sont eux qui reçoivent l'un le signal de commutation, et l'autre le signal inverse de commutation. Ces signaux de commutation sont des signaux logiques dont le niveau est 0 ou Vcc.

Les transistors du haut sont de type P et ont leurs sources connectées à un noeud recevant le signal de haute tension. Ils ont chacun leur grille connectée au drain du transistor du haut de l'autre branche. Ils sont encore appelés transistors de charge.

Le principe de fonctionnement est le suivant : En fonction des niveaux des signaux de commutation, il y a toujours un transistor N de commutation qui est bloqué, le transistor N de commutation de l'autre branche étant passant. Ce transistor N passant tire son drain vers 0 volt (le potentiel de sa source), et le transistor P de l'autre branche qui a sa grille connectée à ce drain devient passant : il amène donc son drain propre à la tension de sa source, à savoir au niveau de l'entrée haute tension.

Ainsi, sur chaque noeud de connexion des drains des transistors N et P d'une même branche, on trouve soit la masse; soit le niveau de l'entrée haute tension.

Ces commutateurs comprennent habituellement un étage intermédiaire, entre l'étage des transistors du haut et l'étage des transistors du bas. Cet étage intermédiaire comprend un ou plusieurs étages cascodes. Il permet de limiter à des niveaux de tension intermédiaires les noeuds internes du commutateur, en sorte qu'aucun transistor du commutateur ne voit une trop haute tension à ses bornes.

Dans certains circuits de l'état de la technique, tous les transistors MOS(N ou P) de l'étage cascode sont polarisés sur leur grille par la tension d'alimentation logique Vcc. Cette polarisation limite la plage de fonctionnement du commutateur. Le basculement du commutateur pour obtenir en sortie le niveau de l'entrée haute tension ne peut en effet se faire que lorsque le niveau de l'entrée est suffisamment élevé, en pratique supérieur à la tension d'alimentation logique Vcc.

Or, avec les technologies MOS à oxyde fin, les basculements du commutateur en haute tension ont des effets transitoires néfastes sur les transistors MOS.

En outre, avec une telle polarisation des grilles des transistors cascodes à la tension d'alimentation logique alors que l'on retrouve sur les drains et sources des transistors cascodes une tension dépendant de l'entrée haute tension, il n'existe aucun lien entre ces tensions, ce qui peut engendrer des stress supplémentaires, si l'écart entre ces deux tensions devient trop important.

Pour ces raisons, on préfère polariser les grilles de ces transistors cascodes à une tension de référence obtenue à partir de l'entrée haute tension elle-même. Ainsi, peut-on contrôler l'écart de tension entre cette tension de référence et l'entrée haute tension, puisque la première dépend de la seconde, assurant ainsi une meilleure protection. Dans le cas d'un étage cascode à transistors MOS N et P, les grilles des transistors de type N de l'étage cascode sont alors habituellement polarisées à une tension de référence V_{REFₙ} supérieure à une tension de référence V_{REFₚ} qui polarise la grille des transistors de type P de l'étage cascode. Ceci permet d'abaisser la limite basse de basculement du commutateur.

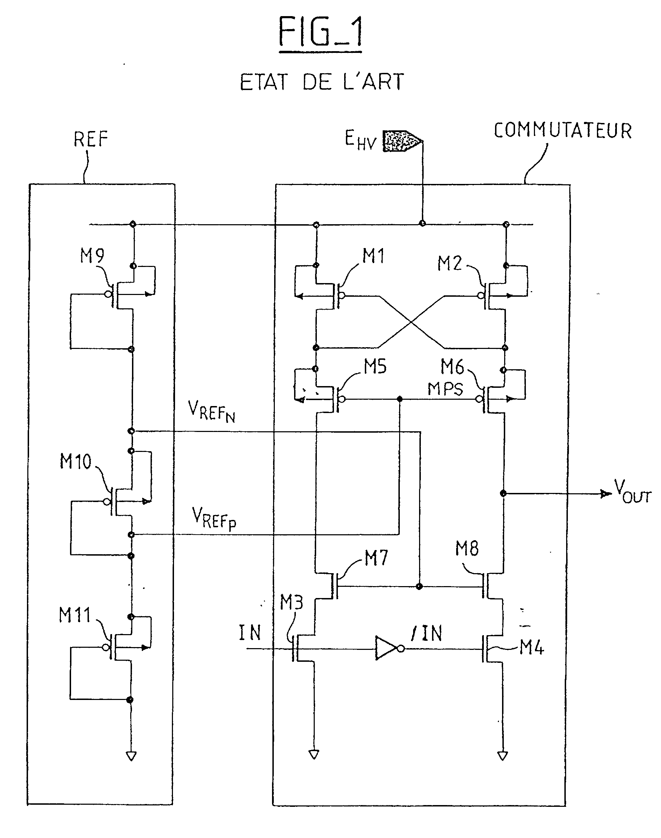

Un exemple d'un commutateur à étage cascode de ce type est représenté sur la figure 1.

Dans cet exemple, l'étage du haut comprend dans la première branche, un transistor Mos de type P, M1, et dans la deuxième branche, un transistor Mos de type P, M2. Ces transistors reçoivent sur leur source, l'entrée haute tension E_{HV}.

L'étage du bas comprend un transistor Mos de type N, M3, et dans la deuxième branche, un transistor Mos de type N, M4. Ces transistors ont leur source connectée à la masse G_{ND}.

L'étage cascode comprend quatre transistors Mos : deux transistors Mos de type P, M5 et M6, un dans chaque branche, sous chaque transistor du haut et deux transistors Mos de type N, M7 et M8, un dans chaque branche, au-dessus de chaque transistor du bas. Les transistors MOS P M5 et M6 reçoivent la tension de référence V_{REFₚ} sur leur grille. Les transistors MOS N M7 et M8 reçoivent la tension de référence V_{REFₙ} sur leur grille.

La sortie V_{OUT} du commutateur est prise entre les transistors cascodes N et P d'une branche, aux drains des transistors M6 et M8 dans l'exemple.

La grille du transistor du bas M3 de la première branche du commutateur reçoit un signal logique de commutation noté IN, et la grille du transistor du bas M4 de la deuxième branche du commutateur reçoit le signal inverse, noté /I_{N}.

Le circuit R_{EF} de génération des tensions de référence V_{REF_{N}} et V_{REF_{P}} comprend trois transistors Mos M9, M10, M11 en série entre la haute tension V_{PP} et la masse. Ces trois transistors fonctionnent en résistance puisqu'il ont chacun leur grille reliée à leur drain. Dans l'exemple, ils sont de type P. Les tensions de référence V_{REFₙ} et V_{REFₚ} sont obtenues en prenant la tension de part et d'autre du transistor du milieu et M10.

Le rôle de l'étage cascode est de limiter à des niveaux intermédiaires les tensions vues par les transistors.

Chaque transistor cascode de type P est polarisé de manière à rester toujours passant. Ainsi sa source, et donc, le drain du transistor de charge P auquel il est connecté, ne peuvent pas descendre en dessous de V_{REF_{P}} - Vtₚ, où Vtₚ est la tension de seuil du transistor cascode de type P.

De même, chaque transistor cascode de type N est polarisé de manière à rester toujours passant. Ainsi sa source, et donc, le drain du transistor de commutation N auquel il est connecté, ne peuvent pas monter au-dessus de V_{REFₙ} - Vtₙ, où Vtₙ est la tension de seuil du transistor cascode de type N.

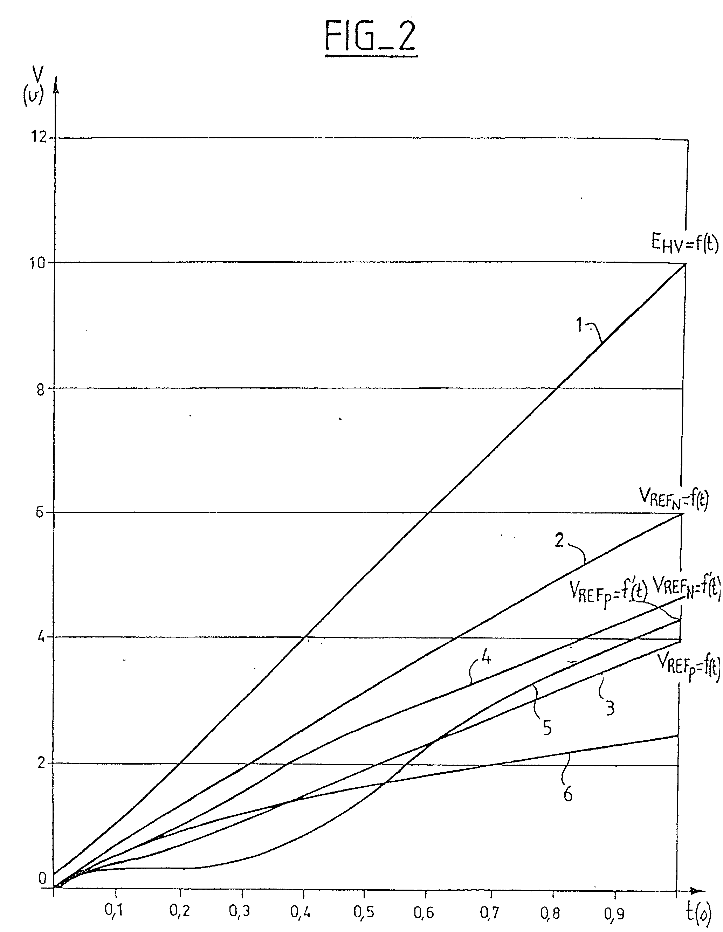

On considère un exemple pratique dans lequel l'entrée haute tension E_{HV} du commutateur se présente sous forme d'une impulsion avec une rampe de montée en tension, comme représenté sur la courbe 1 de la figure 2. Dans l'exemple il croît ainsi linéairement depuis zéro jusqu'à sa valeur nominale V_{PP} (la pente de croissance peut être linéaire, logarithmique exponentielle...).

Les deux courbes 2 et 3 représentent l'évolution des tension de référence, V_{REFₙ}, V_{REFₚ}.

Ces courbes montrent que ces tensions de référence suivent la montée en tension de l'entrée haute tension E_{HV}.

Elles montrent aussi que l'écart entre chacune de ces tensions de référence et le niveau de l'entrée haute tension EHV au départ de la rampe, c'est à dire dans les valeurs basses de tension de l'entrée E_{HV}, ne permet pas aux différents transistors de l'étage cascode de conduire. Dans ces valeurs basses de l'entrée haute tension, le commutateur ne peut donc pas commuter. Dans un exemple pratique pour un circuit alimenté sous Vcc = 3,3 volts, il faut que le niveau de l'entrée haute tension devienne au moins supérieure à 3,8 volts, pour qu'il puisse commuter.

Or commuter dans des valeurs hautes de l'entrée E_{HV} c'est à dire supérieures à Vcc, a pour effet de contribuer à la production d'électrons chauds. La répétition des commandes de commutation multiplie ces électrons chauds. A terme cela dégrade les caractéristiques des transistors du commutateur.

Pour ces différentes raisons, les commutateurs de l'état de la technique ne supportent qu'un nombre limité de commutations.

Un objet de l'invention est de résoudre ce problème technique.

L'idée à la base de l'invention est de faire commuter le commutateur dans les valeurs basses de l'entrée haute tension. Une fois que les transistors ont commuté, le niveau du signal de haute tension peut monter, sans risques pour ces transistors.

Dans l'invention, on a donc cherché un moyen pour faire commuter le commutateur dans les valeurs basses de l'entrée haute tension.

Ceci est obtenu en prévoyant dans le circuit de génération des tensions de référence, que le transistor du milieu qui fournit à ses bornes les deux tensions de référence n'ait plus sa grille commandée par son drain mais par un circuit de commande. Ce circuit de commande comprend deux résistances et une diode, dans un agencement qui permet d'augmenter l'écart de tension avec l'entrée haute tension, dans les valeurs basses de cette entrée haute tension et de limiter la croissance des tensions de référence dans les valeurs hautes.

De cette manière, grâce à une génération appropriée des tensions de référence, on permet la commutation du commutateur dans les valeurs basses de l'entrée haute tension, tout en limitant le niveau des tensions de référence dans les valeurs hautes.

L'invention concerne donc un dispositif de commande d'un commutateur d'une entrée haute tension, à transistors Mos et comprenant au moins un étage cascode, le dispositif de commande comprenant un circuit de génération de référence à partir de l'entrée haute tension pour polariser les transistors Mos de l'étage cascode, et qui fournit en sortie une première et une deuxième tension de référence pris sur le drain et la source d'un transistor MOS, caractérisé en ce qu'il comprend en outre un circuit de commande de la grille de ce transistor à partir de l'entrée haute tension, comprenant une première résistance, une diode et une deuxième résistance connectées en série, le point de connexion entre la diode et l'une des résistances fournissant la tension de commande de grille apte à forcer l'état passant ou bloqué du transistor selon le niveau de l'entrée haute tension.

D'autres caractéristiques et avantages de l'invention sont détaillés dans la description suivante, faite à titre indicatif et non limitatif de l'invention et en référence aux dessins annexés dans lesquels :
- la figure 1 déjà décrite représente un commutateur de haute tension à étage cascode et un circuit de génération des tensions de référence appliquées aux transistors de l'étage cascode selon l'état de la technique ;
- la figure 2 représente les courbes de croissance des tensions de référence obtenues selon l'état de la technique et selon l'invention ;
- la figure 3 représente un circuit de commande du circuit de génération des tensions de référence selon l'invention ;
- les figures 4a et 4b représentent les deux modes de fonctionnement du circuit de la figure 3 ;
- la figure 5 représente une variante de réalisation d'un circuit de commande selon l'invention, pour un circuit de référence de tension à transistors MOS N ; et
- la figure 6 représente un exemple d'application d'un dispositif de commande selon l'invention.

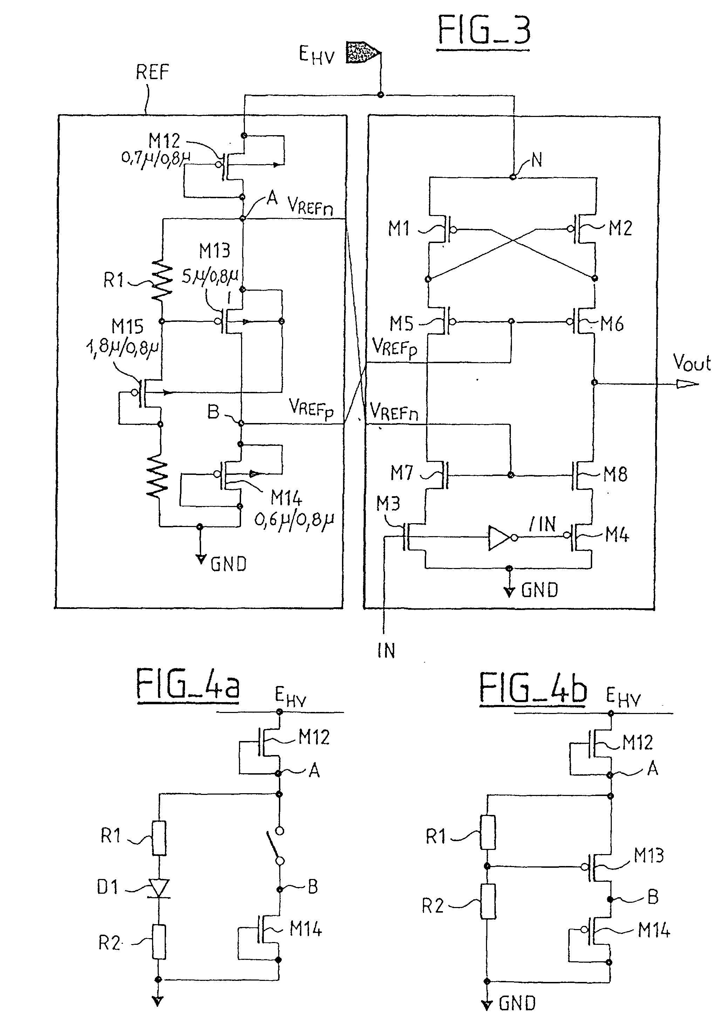

La figure 3 représente un dispositif de commande d'un commutateur d'une entrée haute tension EHV selon l'invention. Dans l'exemple le commutateur comprend un étage cascode. Il pourrait en comporter plusieurs.

Ce dispositif de commande selon l'invention comprend un circuit de commande C_{OM} associé au circuit R_{EF} de génération des tensions de référence appliquées à l'étage cascode (ou aux étages cascodes) du commutateur.

Les éléments constitutifs du commutateur sont les mêmes que ceux décrits en relation avec la figure 1. Pour ces raisons, et pour simplifier l'exposé de l'invention, les éléments communs aux figures 1 et 3 portent les mêmes références.

Dans ce circuit de génération de référence, le transistor qui fournit les tensions de référence V_{REFₙ}, V_{REFₚ}, respectivement sur sa source et sur son drain, a sa grille commandée par le circuit de commande selon l'invention. Ainsi, selon le niveau de l'entrée haute tension, ce circuit de commande peut faire fonctionner ce transistor :
- en résistance, pour des valeurs hautes de l'entrée haute tension ;
- à l'état bloqué, pour des valeurs basses de l'entrée haute tension.

De façon plus détaillée, le circuit de référence comprend un premier transistor M12 de type P connecté au noeud N recevant l'entrée haute tension E_{HV} et un premier noeud intermédiaire A. Un deuxième transistor M13 de type P est connecté entre le premier noeud intermédiaire A et un deuxième noeud intermédiaire B. Un troisième transistor M14 de type P est connecté entre le deuxième noeud intermédiaire B et la masse.

Le circuit de commande selon l'invention comprend une première résistance R1, une diode D1 et une deuxième résistance R2.

La commande de la grille du deuxième transistor M13 du circuit de génération de référence est fournie par le point de connexion entre la diode D1 et l'une des résistances, la résistance R1 dans l'exemple. Dans cet exemple, la première résistance R1 est connectée entre le premier noeud intermédiaire A et la grille du deuxième transistor M13. La diode D1 et la deuxième résistance R2 sont connectées en série entre la grille du deuxième transistor M13 et la masse.

Ce circuit de commande selon l'invention permet d'obtenir, pour des valeurs faibles de l'entrée haute tension E_{HV}, des potentiels de sortie sur les noeuds intermédiaires A et B proches des tensions d'alimentation, c'est à dire proches de E_{HV}, pour A et de G_{ND} pour B.

En effet, pour des valeurs faibles de l'entrée haute tension E_{HV}, le circuit de commande est dans un état de fonctionnement tel que le transistor M13 est bloqué (ou ouvert). Ces conditions favorisent le fonctionnement du commutateur à basse tension.

Plus précisément, le blocage du transistor M13 est maintenu tant que sa tension V_{grille-source} est faible. Cette tension est pilotée par la diode et les résistances du circuit de commande selon l'invention, en fonction du potentiel au noeud intermédiaire A.

Ce blocage est principalement dû à l'utilisation de la diode D1 sur la grille du deuxième transistor M13, qui l'empêche de devenir passant tant que le niveau de l'entrée est en dessous d'un certain seuil, et les résistances R1 et R2 permettent d'adapter les niveaux de tension et limitent la montée en tension sur les drain et source de ce transistor.

Les deux modes de fonctionnement du circuit de commande selon l'invention en fonction du niveau de l'entrée haute tension E_{HV} sont représentés sur les figures 4a et 4b.

Tant que l'entrée haute tension est faible, le schéma équivalent du circuit est celui de la figure 4a. Le noeud B est à un niveau de tension proche de celui de l'entrée E_{HV}, car la charge dans le transistor M12 est faible. Le noeud B est lui proche du niveau de G_{ND}.

Lorsque l'entrée haute tension E_{HV} devient plus importante, le schéma équivalent du circuit de commande est celui de la figure 4b.

Les niveaux de tension sur les noeuds intermédiaires A et B sont le résultat de la répartition de la chaîne M12, M13 et M14.

Les résistances R1 et R2 permettent d'ajuster le seuil de conduction de la diode par rapport au niveau de l'entrée haute tension E_{HV} et de régler le seuil de conduction du transistor M13, et donc le niveau de la tension de référence V_{REF_{P}}.

En pratique, les résistances sont des éléments passifs, typiquement des résistances en poly silicium. La diode est obtenue par un transistor Mos de type P, M15, dont la grille est reliée à son drain. Dans l'exemple, il s'agit d'un transistor MOS de type P.

De préférence, pour améliorer les performances et en particulier la stabilité des tensions de référence obtenues, on prévoit que le bulk du transistor M15 formant la diode et celui du deuxième transistor M13 sont reliés ensemble et polarisés au potentiel de drain du deuxième transistor M13. On supprime ainsi l'effet substrat et on diminue les risques de claquage des oxydes de grille des transistors MOS.

Sur la figure 2 on a représenté les nouvelles courbes 4 et 5 de montée en tension obtenues avec le circuit de commande selon l'invention.

La courbe 5 correspondant à la deuxième tension de référence V_{REFₚ} suit une forme en S. Tant que le niveau de l'entrée haute tension E_{HV} n'a pas dépassé environ deux volts, la tension de référence V_{REF_{P}} reste pratiquement nulle. Ainsi, dans les valeurs basses du signal de haute tension, l'écart de tension entre le niveau de l'entrée haute tension E_{HV} et la tension de référence V_{REF_{P}} est alors suffisant pour rendre conducteurs les transistors de type P de l'étage cascode.

Vers les valeurs hautes de l'entrée haute tension, la nouvelle courbe 5 de référence de tension V_{REFₚ} montre une pente de croissance plus forte, par rapport à l'ancienne. Ainsi, l'écart entre cette tension de référence et l'entrée haute tension ne devient-il pas trop élevé, contrairement à ce qui se passe dans l'état de la technique (courbe 3). Les transistors cascodes de type P ne sont plus soumis à de trop fortes tensions.

On limite ainsi l'émission d'électrons chauds. La résistance des transistors au nombre de commutation est ainsi améliorée.

On obtient les mêmes avantages pour les transistors cascodes de type N polarisés par la référence de tension V_{REF_{N}}. La nouvelle courbe correspondante 4 montre une forme en S moins prononcée que l'ancienne courbe. Au départ, dans les faibles valeurs de l'entrée E_{HV} haute tension, le niveau de V_{REF_{N}} est proche de celui de l'entrée E_{HV}. Ensuite le niveau de V_{REF_{N}} croît nettement moins vite avec l'entrée E_{HV} que dans l'état de la technique et sa pente de croissance faiblie dans les valeurs hautes de l'entrée haute tension. Dans ces valeurs hautes, elle tend à se rapprocher de la courbe 5 de la deuxième référence de tension V_{REFₚ}.

La courbe 6 montre quant à elle l'évolution de la tension sur la grille du deuxième transistor M13.

La taille de la diode et les valeurs des résistances permettent de jouer sur cette courbe et donc sur le seuil de mise en conduction du transistor M13 et les valeurs finales des tensions de référence V_{REFₙ} et V_{REFₚ}.

Le circuit de commande de l'invention permet donc d'élargir la fenêtre de fonctionnement du commutateur. Les éléments du circuit de commande sont dimensionnés en fonction des différentes contraintes sur les transistors de l'étage cascode, de manière à obtenir la courbe optimum pour chaque référence de tension.

L'invention a été décrite dans un exemple de commutateur de type Cmos (à transistors N et P) dont l'étage cascode utilise aussi des transistors N et P.

Elle s'applique plus généralement à un commutateur à transistors Mos à un ou plusieurs étages cascodes.

Elle s'applique aussi dans le cas où l'étage cascode utilise seulement des transistors MOS P ou des transistors MOS N. Dans ce cas, une seule référence de tension peut-être nécessaire, que l'on prendra sur l'un des noeuds intermédiaires, c'est à dire sur le drain ou la source du transistor M13.

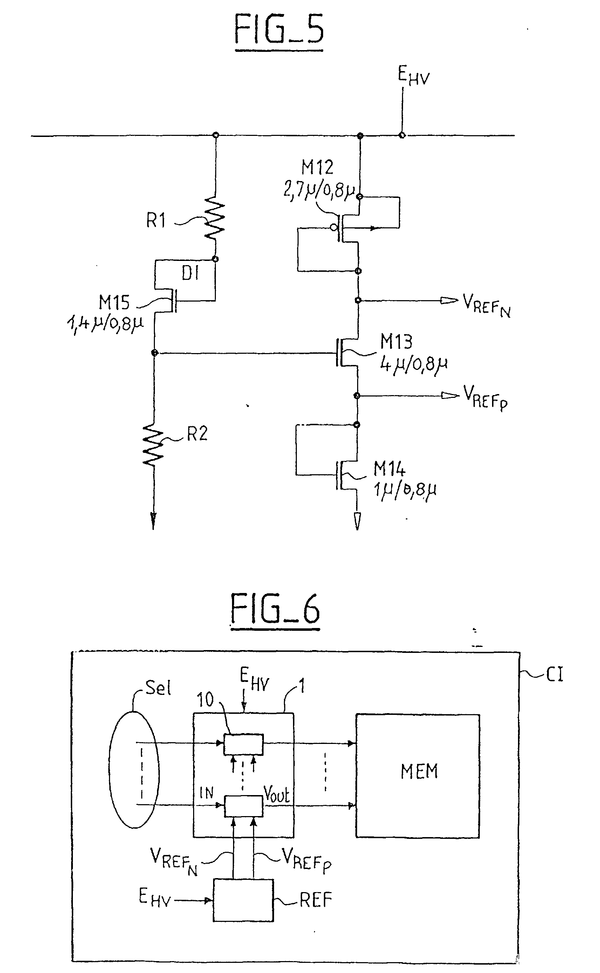

La figure 5 représente une variante de réalisation d'un circuit de commande selon l'invention, qui utilise un transistors MOS de type N pour le transistor M13. De préférence le transistor M12 reste du type PMOS pour garder une meilleure tenue en tension et une bonne résistance contre les ESD. Dans ce cas, pour assurer le bon fonctionnement du circuit de commande, la commande de grille du transistor M13 du circuit de génération de référence est fournie par le point de connexion entre la diode D1 et la résistance R2. la résistance R1 et la diode D1 sont connectées en série entre l'entrée haute tension E_{HV} et la grille du transistor M13 et la résistance R2 se retrouve entre cette grille et la masse G_{ND}.

De préférence, le transistor Mos formant la diode D1 sera de même type que le transistor M13, N dans l'exemple.

Enfin, le transistor M14 peut aussi bien être du type PMOS que du type NMOS, que ce soit dans le circuit de la figure 5 que dans le circuit de la figure 3.

Le dispositif de commande selon l'invention est peu coûteux par rapport à celui de l'état de la technique. Il ne nécessite que deux résistances, qui sont des éléments passifs, et un transistor pour la diode.

En outre, le dispositif de commande selon l'invention est capable de commander plusieurs commutateurs en même temps. En d'autres termes, la ou les tensions de référence fournies par le circuit de génération R_{EF} et son circuit de commande COM peut ou peuvent être appliquées à plusieurs commutateurs. Ceci est particulièrement avantageux dans une application pour la commutation d'une tension de programmation sur des éléments mémoires.

Un tel exemple d'application est schématiquement représenté sur la figure 6. Dans cet exemple, un circuit intégré CI comprend une mémoire MEM non volatile électriquement programmable. Pour appliquer une tension de programmation sur des éléments de la mémoire, afin de les programmer, un circuit 1 de commutateurs haute tension 10 est prévu. Il reçoit en entrée des signaux logiques (sel) de sélection d'éléments mémoire. Chaque signal logique est appliqué conne entrée de commande IN d'un commutateur du circuit 1, afin d'appliquer la haute tension sur des éléments de la mémoire sélectionnés. Dans l'exemple, un dispositif de commande selon l'invention est prévu pour fournir les tensions de références V_{REF_{P}} et V_{REFₙ} à chacun des commutateurs 10.

On notera que l'invention s'applique aussi bien pour la' programmation d'éléments mémoire, de type EPROM, EEPROM ou autres organisés selon une matrice que pour la programmation d'éléments mémoires discrets, répartis dans des circuits internes, par exemple, dans des circuits de redondance. Dans ce cas, il peut s'agir de fusibles électriquement programmables.

## Revendications

1. Dispositif de commande d'un commutateur d'une entrée haute tension (E_{HV}) à transistors Mos et comprenant au moins un étage cascode, le dispositif de commande comprenant un circuit de génération de référence (R_{EF}) à partir de l'entrée haute tension (E_{HV}), pour polariser les transistors Mos de l'étage cascode et qui fournit en sortie une première et une deuxième tension de référence (V_{REFₙ}, V_{REFₚ}) pris sur le drain et la source d'un transistor MOS(M13), **caractérisé en ce qu'**il comprend en outre un circuit de commande de la grille de ce transistor à partir de l'entrée haute tension (E_{HV}), comprenant une première résistance (R1), une diode (D1) et une deuxième résistance (R2) connectées en série, le point de connexion entre la diode et l'une des résistances fournissant la tension de commande de grille apte à forcer l'état passant ou bloqué du transistor selon le niveau de l'entrée haute tension.

2. Dispositif selon la revendication 1, le circuit de génération de référence comprenant un premier transistor Mos (M12) connecté entre l'entrée haute tension (E_{HV}) et un premier noeud intermédiaire (A), un deuxième transistor Mos (M13) connecté entre le premier noeud intermédiaire (A) et un deuxième noeud intermédiaire (B) et un troisième transistor Mos connecté entre le deuxième noeud intermédiaire (B) et la masse (G_{ND}), une tension de référence étant obtenue sur l'un ou l'autre des noeuds intermédiaires, **caractérisé en ce que** la commande de grille est appliquée au deuxième transistor (M13), les premier et troisième transistors ayant chacun leur grille et leur drain reliés.

3. Dispositif selon la revendication 1 ou 2, **caractérisé en ce que** les première et deuxième résistances (R1, R2) sont des éléments passifs.

4. Dispositif selon la revendication 2 ou 3, **caractérisé en ce que** le deuxième transistor MOS (M13) est de type P, la première résistance (R1) étant connectée entre le premier noeud intermédiaire et la grille de ce transistor, la diode (D1) et la deuxième résistance (R2) étant connectées entre cette grille et la masse (G_{ND}).

5. Dispositif selon la revendication 4, **caractérisé en ce que** la diode est formée par un transistor MOS de type P (M15), ayant sa grille reliée à son drain.

6. Dispositif selon la revendication 5, **caractérisé en ce que** le bulk du transistor (M15) formant la première diode (D1) et celui du deuxième transistor (M13) sont connectés en commun au premier noeud intermédiaire (A).

7. Dispositif selon la revendication 2 ou 3, **caractérisé en ce que** le deuxième transistor (M13) est de type N, la première résistance (R1) et la diode (D1) étant connectées entre l'entrée haute tension (EHV) et la grille de ce transistor, et la deuxième résistance (R2) étant connectée entre cette grille et la masse (G_{ND}).

8. Dispositif selon la revendication 7, **caractérisé en ce que** la diode est formée d'un transistor MOS de type N (M15) ayant sa grille reliée à son drain.

9. Dispositif selon l'une quelconque des revendications 2 à 8, **caractérisé en ce que** le premier transistor MOS (M12) est de type P.

10. Circuit intégré comprenant des éléments mémoire non volatile électriquement programmables, **caractérisé en ce qu'**il comprend au moins un dispositif de commande selon l'une quelconque des revendications précédentes, appliqué à au moins un commutateur d'une entrée haute tension pour la programmation d'éléments mémoire.

## Claims

1. Device for controlling a switch with a high-voltage input (E_{HV}) with MOS transistors and comprising at least one cascode stage, the control device comprising a circuit (R_{EF}) for generating a reference from the high-voltage input (E_{HV}), to bias the MOS transistors of the cascode stage, and which supplies as an output first and second reference voltages (V_{REFₙ}, V_{REFₚ}) taken at the drain and source of an MOS transistor (M13), **characterised in that** it also comprises a circuit for controlling the gate of this transistor from the high-voltage input (E_{HV}), comprising a first resistor (R1), a diode (D1) and a second resistor (R2) connected in series, the connection point between the diode and one of the resistors supplying the gate control voltage able to force the on or off state of the transistor according to the level of the high-voltage input.

2. Device according to Claim 1, the reference generating circuit comprising a first MOS transistor (M12) connected between the high-voltage input (E_{HV}) and a first intermediate node (A), a second MOS transistor (M13) connected between the first intermediate node (A) and a second intermediate node (B) and a third MOS transistor connected between the second intermediate node (B) and earth (G_{ND}), a reference voltage being obtained at one or other of the intermediate nodes, **characterised in that** the gate control is applied to the second transistor (M13), the first and third transistors each having their gate and drain connected.

3. Device according to Claim 1 or 2, **characterised in that** the first and second resistors (R1, R2) are passive elements.

4. Device according to Claim 2 or 3, **characterised in that** the second MOS transistor (M13) is of the p type, the first resistor (R1) being connected between the first intermediate node and the gate of this transistor, the diode (D1) and the second resistor (R2) being connected between this gate and earth (G_{ND}).

5. Device according to Claim 4, **characterised in that** the diode is formed by a p-type MOS transistor (M15), having its gate connected to its drain.

6. Device according to Claim 5, **characterised in that** the bulk of the transistor (M15) forming the first diode (D1) and that of the second transistor (M13) are connected in common to the first intermediate node (A).

7. Device according to Claim 2 or 3, **characterised in that** the second transistor (M13) is of type n, the first resistor (R1) and the diode (D1) being connected between the first high-voltage input (E_{HV}) and the gate of this transistor, and the second resistor (R2) being connected between this gate and earth (G_{ND}).

8. Device according to Claim 7, **characterised in that** the diode is formed by an n-type MOS transistor (M15) having its gate connected to its drain.

9. Device according to any one of Claims 2 to 8, **characterised in that** the first MOS transistor (M12) is of the p type.

10. Integrated circuit comprising electrically programmable non-volatile memory elements, **characterised in that** it comprises at least one control device according to any one of the preceding claims, applied to at least one switch with a high-voltage input for programming memory elements.

## Patentansprüche

1. Steuerschaltung für einen Wandler eines Hochspannungseingangs (EHV) mit MOS-Transistoren sowie wenigstens einer Kaskadenstufe, wobei die Steuerschaltung einen Referenzgeneratorschaltkreis (REF) zu dem Hochspannungseingang (EHV) zum Vorspannen der MOS-Transistoren der Kaskadenstufe und zum Erzeugen einer ersten und einer zweiten Referenzspannung (VREF_{N}, VREF_{P}) an dem Drain und der Source eines MOS-Transistors (M13) umfasst, **dadurch gekennzeichnet, dass** sie außerdem einen Steuerschaltkreis für das Gate dieses Transistors in Abhängigkeit von dem Hochspannungseingang (EHV) umfasst mit einem ersten Widerstand (R1), einer Diode (D1) und einem zweiten Widerstand (R2), die in Reihe geschaltet sind, wobei am Verbindungspunkt zwischen der Diode und dem einen der Widerstände die Steuerspannung für das Gate erzeugt wird, die geeignet ist, je nach Pegel des Hochspannungseingangs den leitenden oder sperrenden Zustand des Transistors herzustellen.

2. Schaltung nach Anspruch 1, wobei der Referenzgeneratorschaltkreis einen ersten MOS-Transistor (M12) zwischen dem Hochspannungseingang (EHV) und einem ersten Zwischenknoten (A), einen zweiten MOS-Transistor (M13) zwischen dem ersten Zwischenknoten (A) und einem zweiten Zwischenknoten (B) und einen dritten MOS-Transistor zwischen dem zweiten Zwischenknoten (B) und Masse (GND) umfasst, wobei eine Referenzspannung an dem einen oder anderen der Zwischenknoten erzeugt wird, **dadurch gekennzeichnet, dass** die Gate-Steuerung an den zweiten Transistor (M 13) angelegt wird, wobei bei dem ersten und dritten Transistor jeweils Gate und Drain verbunden sind.

3. Schaltung nach Anspruch 1 oder 2, **dadurch gekennzeichnet, dass** der erste und zweite Widerstand (R1, R2) passive Elemente sind.

4. Schaltung nach Anspruch 2 oder 3, **dadurch gekennzeichnet, dass** der zweite MOS-Transistor (M13) vom P-Typ ist, der erste Widerstand (R1) zwischen den ersten Zwischenknoten und das Gate dieses Transistors geschaltet ist und die Diode (D1) und der zweite Widerstand (R2) zwischen dieses Gate und Masse (GND) geschaltet sind.

5. Schaltung nach Anspruch 4, **dadurch gekennzeichnet, dass** die Diode gebildet wird durch einen PMOS-Transistor (M15), dessen Gate mit seinem Drain verbunden ist.

6. Schaltung nach Anspruch 5, **dadurch gekennzeichnet, dass** der Bulk-Bereich des Transistors (M15) die erste Diode (D1) bildet und zusammen mit demjenigen des zweiten Transistors (M13) mit dem ersten Zwischenknoten (A) verbunden ist.

7. Schaltung nach Anspruch 2 oder 3, **dadurch gekennzeichnet, dass** der zweite Transistor (M13) vom N-Typ ist, der erste Widerstand (R1) und die Diode (D1) zwischen den Hochspannungseingang (EHV) und das Gate dieses Transistors geschaltet sind und der zweite Widerstand (R2) zwischen dieses Gate und Masse (GND) geschaltet ist.

8. Schaltung nach Anspruch 7, **dadurch gekennzeichnet, dass** die Diode aus einem NMOS-Transistor (M15) gebildet wird, dessen Gate mit seinem Drain verbunden ist.

9. Schaltung nach einem der Ansprüche 2 bis 8, **dadurch gekennzeichnet, dass** der erste MOS-Transistor (M12) vom P-Typ ist.

10. Integrierter Schaltkreis mit elektrisch programmierbaren nicht flüchtigen Speicherelementen, **dadurch gekennzeichnet, dass** er wenigstens eine Steuerschaltung nach einem der vorangehenden Ansprüche umfasst, die verwendet wird für wenigstens einen Wandler eines Hochspannungseingangs für die Programmierung von Speicherelementen.
